# EUROPEAN PATENT SPECIFICATION

(11) **EP 3 410 499 B1**
(45) Date of publication and mention of the grant of the patent: **10.05.2023**
(21) Application number: 16888128.2
(22) Date of filing: 24.11.2016
(51) Int. Cl.: H01L 33/54, B29C 45/14, H01L 33/60, H01L 33/62, H01L 33/64

(54) **LIGHT EMITTING DEVICE, AND MANUFACTURING METHOD OF LIGHT EMITTING DEVICE**
LICHTEMITTIERENDE VORRICHTUNG UND HERSTELLUNGSVERFAHREN FÜR EINE LICHTEMITTIERENDE VORRICHTUNG
DISPOSITIF ÉLECTROLUMINESCENT ET PROCÉDÉ DE FABRICATION DE DISPOSITIF ÉLECTROLUMINESCENT

(30) Priority: 27.01.2016 JP 2016013707
(43) Date of publication of application: 05.12.2018
(73) Proprietor: Omron Corporation, Kyoto-shi, Kyoto 600-8530 (JP)
(72) Inventor: KAWAI, Wakahiro, Kyoto-shi, Kyoto 600-8530 (JP)
(74) Representative: Becker Kurig & Partner Patentanwälte mbB
(86) International application number: PCT/JP2016/084781
(87) International publication number: WO 2017/130544

(56) References cited:
- WO-A1-2014/064871
- WO-A1-2014/084175
- WO-A1-2014/100652
- JP-A- 2012 099 545
- JP-A- 2015 177 005
- JP-A- 2015 207 703
- US-A1- 2014 167 092
- US-A1- 2014 284 645

## Description

### [Technical Field]

The present invention relates to a light emitting device having a light emitting element such as a light emitting diode (LED) element.

### [Background Art]

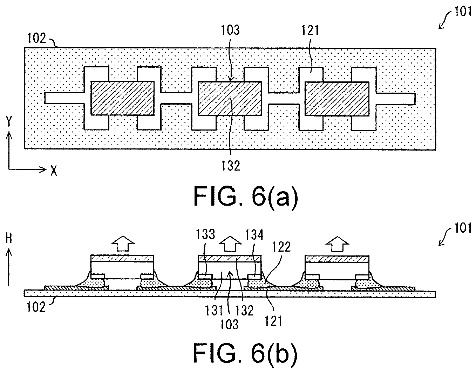

Conventionally, a light emitting device having a plurality of light emitting diode (LED) elements is often used as an optical printer head used in a printer of an electrophotographic-type or the like, or a light emitting electronic device used in an optical display device or the like. An example of such a light emitting device is illustrated in Fig. 6(a) to Fig. 6(b).

Fig. 6(a) to Fig. 6(b) are diagrams illustrating a configuration of a light emitting device 101 according to a conventional technology. As illustrated in Fig. 6(a), the light emitting device 101 includes a printed circuit board 102 and a plurality of LED elements 103. As illustrated in Fig. 6(b), the LED element 103 includes a base portion 131, a light emitting unit 132, an anode 133, and a cathode 134.

On a surface of the printed circuit board 102, an interconnection 121 is formed by a method such as etching.

The light emitting unit 132 formed of a light emitting diode is provided on one surface of the base portion 131. Further, the anode 133 and the cathode 134 are provided on the other surface of the base portion 131. Each of the LED elements 103 is mounted on the surface of the printed circuit board 102 by connecting the anode 133 and the cathode 134 to the interconnection 121 using a solder material 122.

However, in the configuration in which the LED element 103 is mounted on the surface of the printed circuit board 102 as in the light emitting device 101 illustrated in Fig. 6, due to thermal contraction or the like of the solder material 122 when the solder material 122 is cured, there is a possibility of a height and a mounting position of the LED element 103 deviating from specifications. When such deviation occurs, a problem in which light emission characteristics of the completed light emitting device 101 deviate from the specifications occurs. Further, there is also a problem in which characteristics of the LED element 103 are changed due to application of high temperature heat for curing the solder material 122.

Further, due to an increasing demand for miniaturization and thinning of electronic devices in recent years, miniaturization of light emitting devices is required. However, in the light emitting device 101 obtained by a mounting method using the conventional solder material 122, it is necessary to secure a space for installing the solder material 122 in the light emitting device 101 from a viewpoint of wet-spreading of the solder material 122 or ensuring mounting strength. Therefore, the miniaturization of the light emitting device 101 is limited.

Thus, conventionally, various countermeasures against such deviation of the LED position at the time of surface mounting with the solder material have been proposed.

Patent Literature 1 discloses a method of fixing a mounting position of an LED by forming a groove at an LED mounting position on a printed circuit board and inserting an LED member joined with a dummy having the same dimension as a mounting pitch of the LED into the groove.

Patent Literature 2 discloses a method of fixing a mounting position of an LED by applying an adhesive in a hole formed in a printed circuit board, mounting an LED on the adhesive, and curing it.

Patent Literature 3 discloses a method of fixing a mounting position of an LED by assembling an LED with a member whose positioning has been performed once and then soldering the LED to a circuit of a printed circuit board.

### [Citation List]

### [Patent Literature]

[Patent Literature 1]
   Japanese Unexamined Patent Application Publication No. S64-25582 (Publication date: January 27, 1989)
[Patent Literature 2]
   Japanese Unexamined Patent Application Publication No. H11-219961 (Publication date: August 10, 1999)
[Patent Literature 3]
   Japanese Unexamined Patent Application Publication No. 2008-16297 (Publication date: January 24, 2008)
[Patent Literature 4]
   Japanese Unexamined Patent Application Publication No. H05-150807 (Publication date: July 30, 1993)
[Patent Literature 5]
   Japanese Unexamined Patent Application Publication No. H09-179512 (Publication date: July 11, 1997)

US 2014/284645 A1 discloses an optoelectronic semiconductor component including an optoelectronic semiconductor chip having side areas covered by a shaped body, at least one plated-through hole including an electrically conductive material, and an electrically conductive connection electrically conductively connected to the semiconductor chip and the plated-through hole, wherein, the plated-through hole is arranged in a manner laterally spaced apart from the semiconductor chip, the plated-through hole completely penetrates through the shaped body, and the plated-through hole extends from a top side of the shaped body to an underside of the shaped body. The electrically conductive connection extends at the top side of the shaped body.US 2014/167092 A1 discloses a optoelectronic assembly including a carrier, an optoelectronic component arranged on the carrier, wherein the optoelectronic component includes a substrate and a light-emitting layer arranged on the substrate, and a light-reflecting first encapsulation at least locally covers a region of the carrier surrounding the optoelectronic component and side surfaces of the optoelectronic component.

### [Summary of Invention]

### [Technical Problem]

However, in these conventional technologies, it is difficult to realize accuracy of an LED mounting position in micron units from a viewpoint of the processing accuracy of substrate processing, a dummy member, an assembling member, and the like. Also, there is a problem in that processing spaces for grooves or holes, or installation spaces for dummy members or assembling members are required, thereby increasing a size of the light emitting device. Further, there are additional problems in that additional processing is applied to the printed circuit board, manufacturing cost is increased for fabrication of assembling members, and manufacturing yield is lowered due to complicated manufacturing steps.

The present invention has been made to solve the problems described above. The object is to realize a more compact and thinner light emitting device, and a method for more easily manufacturing such a light emitting device.

### [Solution to Problem]

The present invention is provided in the appended claims. The following disclosure provides a better understanding of the invention.

### [Advantageous Effects of Invention]

According to one aspect of the present invention, it is possible to realize a more compact and thinner light emitting device, and a method for more easily manufacturing such a light emitting device.

### [Brief Description of Drawings]

Fig. 1(a) to Fig. 1(c) are diagrams illustrating a configuration of a light emitting device according to Embodiment 1 of the present invention.
Fig. 2(a) to Fig. 2(d) are diagrams for describing a method of manufacturing the light emitting device according to Embodiment 1 of the present invention.
Fig. 3 is a diagram showing deviation amounts from designed numerical values of mounting distances of light emitting diode (LED) elements in the light emitting device according to the present embodiment.
Fig. 4(a) to Fig. 4(c) are diagrams illustrating a structure of a light emitting device according to Embodiment 2 of the present invention.
Fig. 5(a) to Fig. 5(c) are diagrams illustrating a structure of a light emitting device according to Embodiment 6 of the present invention.
FIG. 6 (a) to Fig. 6(b) are diagrams illustrating a configuration of a light emitting device according to a conventional technology.

### [Description of Embodiments]

### [Embodiment 1]

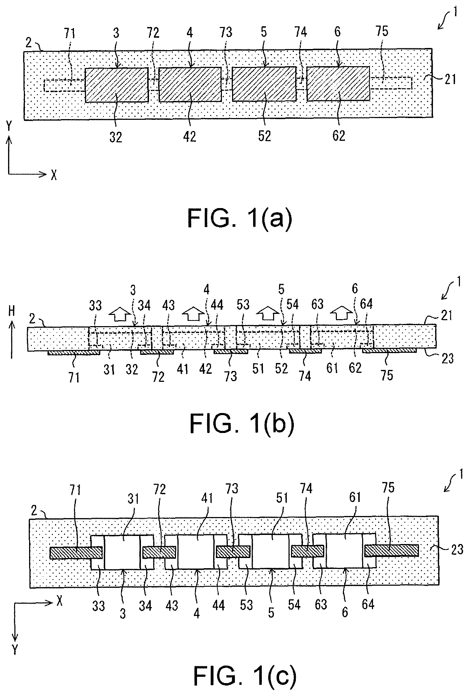

Embodiment 1 according to the present invention will be described below with reference to Figs. 1 to 3.

Fig. 1 (a) to Fig. 1(c) are diagrams illustrating a configuration of a light emitting device 1 according to Embodiment 1 of the present invention. Fig. 1(a) is a diagram of the light emitting device 1 viewed from a light emitting surface (front surface) thereof, Fig. 1(b) is a diagram of the light emitting device 1 viewed from a surface perpendicular to the light emitting surface (side surface), and Fig. 1(c) is a diagram of the light emitting device 1 viewed from a surface opposite to the light emitting surface (back surface).

As illustrated in Fig. 1(a) to Fig. 1(c), the light emitting device 1 includes a resin molded body 2, LED elements (light emitting diode elements, light emitting elements) 3 to 6, and interconnections 71 to 75.

The resin molded body 2 serves as a base of the light emitting device 1 and is formed of any of various types of resin materials. As such a material, polycarbonate (PC) or acrylonitrile butadiene styrene (ABS) can be exemplified.

The LED elements 3 to 6 are surface mounted device (SMD) type LED elements. As illustrated in Fig. 1(a) to Fig. 1(c), the LED element 3 includes a base portion 31, a light emitting unit 32, an anode 33 (electrode), and a cathode 34 (electrode). The LED element 4 includes a base portion 41, a light emitting unit 42, an anode 43 (electrode), and a cathode 44 (electrode). The LED element 5 includes a base portion 51, a light emitting unit 52, an anode 53 (electrode), and a cathode 54 (electrode). The LED element 6 includes a base portion 61, a light emitting unit 62, an anode 63 (electrode), and a cathode 64 (electrode).

The base portion 31 is a main body portion of the LED element 3. The light emitting unit 32 made of an LED is formed on a surface of the base portion 31. When the LED element 3 emits light, the light is emitted from the light emitting unit 32. The anode 33 and the cathode 34 are connection electrodes connected to an external part of the light emitting device 1 or to any one of the other LED elements 4 to 6 in the light emitting device 1. The anode 33 and the cathode 34 are formed on the back surface opposite to the front surface of the base portion 31.

Since detailed configuration of the LED elements 4 to 6 is the same as that of the LED element 3, detailed description thereof will be omitted.

The LED elements 3 to 6 are embedded in the resin molded body 2. As illustrated in Fig. 1(a) to Fig. 1(c), four LED elements 3 to 6 are linearly disposed in the light emitting device 1. As illustrated in Fig. 1(a), the light emitting units 32 to 62 are exposed on a front surface 21 of the resin molded body 2. Therefore, as indicated by arrows in Fig. 1(b), when the light emitting device 1 emits light, the light is emitted from the front surface 21 of the resin molded body 2.

As illustrated in Fig. 1(c), the anodes 33 to 63 and the cathodes 34 to 64 are exposed on a back surface 23 opposite to the front surface 21 of the resin molded body 2.

The interconnections 71 to 75 are formed on the back surface 23 of the resin molded body 2 and are connected to at least one of the corresponding anodes 33 to 63 or cathodes 34 to 64. The interconnections 71 to 75 are formed by printing on the back surface 23 of the resin molded body 2 by a printing method using silver ink or the like, for example. Therefore, a solder material is unnecessary for connecting the interconnections 71 to 75 with the anodes 33 to 63 or the cathodes 34 to 64.

As illustrated in Fig. 1(a) to Fig. 1(c), one end of the interconnection 71 is connected to the anode 33. The other end of the interconnection 71 is connected to a drive circuit (not illustrated) outside the light emitting device 1. One end of the interconnection 72 is connected to the cathode 34 and the other end is connected to the anode 43. In this manner, the interconnection 72 serves the role of connecting the LED element 3 and the LED element 4.

One end of the interconnection 73 is connected to the cathode 44 and the other end is connected to the anode 53. In this manner, the interconnection 73 serves the role of connecting the LED element 4 and the LED element 5.

One end of the interconnection 74 is connected to the cathode 54 and the other end is connected to the anode 63. In this manner, the interconnection 74 serves the role of connecting the LED element 5 and the LED element 6.

One end of the interconnection 75 is connected to the cathode 64. The other end of the interconnection 75 is connected to a drive circuit (not illustrated) outside the light emitting device 1.

As described above, the LED elements 3 to 6 are connected in series with each other using the interconnections 71 to 75. Therefore, when the LED elements 3 to 6 are driven all at once by the external drive circuit, the LED elements 3 to 6 emit light at the same time.

The light emitting device 1 according to the present embodiment is suitably used for an optical printer head or the like mounted on an electrophotographic printer. Particularly, since the light emitting surface of the light emitting device 1 and a surface on which the interconnections 71 to 75 are formed respectively correspond to the front surface and the back surface of the light emitting device 1, it is possible to improve assemblability of the drive circuit for driving the LED elements 3 to 6 or the other parts constituting the printer with the light emitting device 1.

### (Method of manufacturing the light emitting device 1)

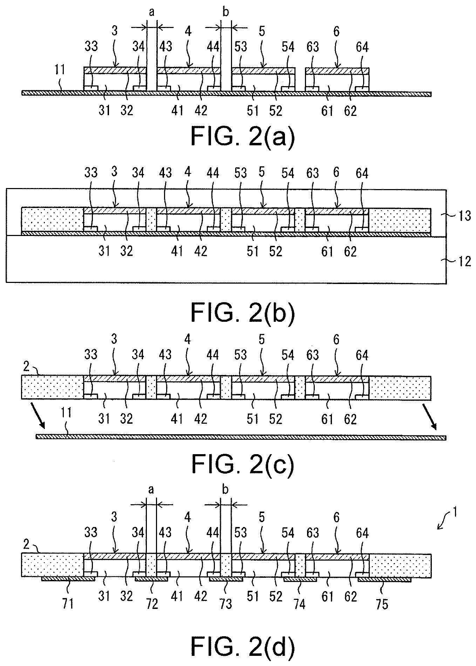

Fig. 2(a) to Fig. 2(d) are diagrams for describing a method of manufacturing the light emitting device 1 according to the present embodiment. A method of manufacturing the light emitting device 1 according to the present embodiment will be described below with reference to Fig. 2(a) to Fig. 2(d).

### (Temporary fixing step)

First, as illustrated in Fig. 2(a), a temporary fixing film 11 for temporarily fixing the LED elements 3 to 6 is prepared and the LED elements 3 to 6 are temporarily fixed to the temporary fixing film 11. As the temporary fixing film 11, for example, a film made of polyethylene terephthalate (PET) can be used.

In the present embodiment, the LED elements 3 to 6 are temporarily fixed to the temporary fixing film 11 using an adhesive or the like so that the anodes 33 to 63 and the cathodes 34 to 64 of the LED elements 3 to 6 come into contact with the temporary fixing film 11. For this temporary fixing, for example, an ultraviolet curable adhesive (not illustrated) applied to the temporary fixing film 11 can be used. Specifically, GL-3005H made by Gluelabo Ltd. is used as the adhesive, and the adhesive is applied to the temporary fixing film 11 made of PET having a thickness of 50 µm to have a thickness of 2 to 3 µm.

Then, positions of the LED elements 3 to 6 in the temporary fixing film 11 are determined, and the LED elements 3 to 6 are installed at the determined positions on the temporary fixing film 11. Thereafter, the temporary fixing film 11 and the LED elements 3 to 6 are irradiated with ultraviolet rays of 3000 mJ/cm² to cure the adhesive. As a result, the LED elements 3 to 6 are temporarily fixed to the temporary fixing film 11.

### (Injection molding step)

Next, as illustrated in Fig. 2(b), the temporary fixing film 11 on which the LED elements 3 to 6 are temporarily fixed in the temporary fixing step is disposed in a gap between a mold 12 and a mold 13, and a resin material is injected into the gap. Thereby, injection molding of the resin material is performed so that the LED elements 3 to 6 are embedded in the resin molded body 2.

As the resin material used for this step, various types of resin materials such as polycarbonate (PC) and acrylonitrile butadiene styrene (ABS) can be exemplified. When PC is used, the PC is used at an injection temperature of 270 °C and an injection pressure of 100 Mpa. When ABS is used, the ABS is used at an injection temperature of 180 °C and an injection pressure of 20 kgf/cm².

### (Peeling Step)

Next, as illustrated in Fig. 2(c), the injection molded product obtained in the injection molding step is taken out from the gap between the mold 12 and the mold 13, and then the temporary fixing film 11 is peeled off from the injection molded product. Thereby, the light emitting units 32 to 62 of the LED elements 3 to 6 are exposed on the front surface of the resin molded body 2. On the other hand, the anodes 33 to 63 and the cathodes 34 to 64 of the LED elements 3 to 6 are exposed on the back surface of the resin molded body 2.

Further, the PET film used as the temporary fixing film 11 is greatly deformed by heat at the time of injection molding in the injection molding step and is in a state in which it has been peeled off from the injection molded product. Therefore, the temporary fixing film 11 can be easily separated from the injection molded product.

### (Interconnection formation step)

Finally, as illustrated in Fig. 2(d), the interconnections 71 to 75 connected to the anodes 33 to 63 and the cathodes 34 to 64 of each of the LED elements 3 to 6 exposed on the back surface 23 of the resin molded body 2 are formed on the back surface 23 of the resin molded body 2. Thereby, the light emitting device 1 is completed.

Various methods can be used for forming the interconnections 71 to 75. A method of print-forming the interconnections 71 to 75 by jetting a conductive material (for example, silver ink or the like) using an ink jet printer or the like, a method of forming the interconnections 71 to 75 using an aerosol, a method of forming the interconnections 71 to 75 using a dispenser, or the like can be exemplified.

### (Deviation amount of mounting distance)

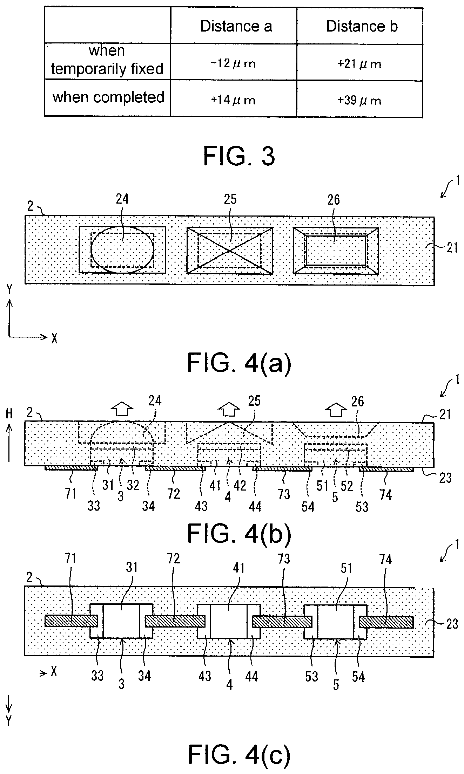

Fig. 3 is a diagram showing deviation amounts from designed numerical values of mounting distances of the LED elements 3 to 6 in the light emitting device 1 according to the present embodiment. As illustrated in Fig. 3, deviation amounts from designed numerical values of a mounting distance a between the LED element 3 and the LED element 4 and a mounting distance b between the LED element 4 and the LED element 5 in the temporary fixing step (at the time of temporary fixing of the LED elements 3 to 6) illustrated in Fig. 2(a) were -12 µm and +21 µm. On the other hand, deviation amounts from designed numerical values of the mounting distance a between the LED element 3 and the LED element 4 and the mounting distance b between the LED element 4 and the LED element 5 in the interconnection formation step (at the time of completion of the light emitting device 1) illustrated in Fig. 2(b) were +14 µm and +39 µm.

As shown in Fig. 3, the deviation amounts of the mounting distances of the LED elements 3 to 6 at the time of temporary fixing hardly change even at the time of completion of the light emitting device 1. Therefore, according to the present embodiment, it is possible to manufacture the light emitting device 1 in which the LED elements 3 to 6 are disposed on the temporary fixing film 11 at the positions at the time of temporary fixing.

### (Advantages of the present embodiment)

The light emitting device 1 illustrated in Fig. 1(a) to Fig. 1(c) does not have a printed circuit board which is necessary for a light emitting device according to a conventional technology and also does not need a solder material for connecting interconnections and electrodes (an anode and a cathode). Thereby, the following effects which contribute to miniaturization and thinning of the light emitting device 1 can be obtained.
(1) Since a height of the light emitting device 1 can be made small enough that it is approximately equal to a height of the LED elements 3 to 6, thinning of the light emitting device 1 can be achieved.
(2) Since spaces between the LED elements 3 to 6 which are necessary for connecting the electrodes of the LED elements and the interconnections by a solder material in the conventional technology are not necessary for the light emitting device 1, pitches (intervals between the LED elements 3 to 6) when the LED elements 3 to 6 are mounted on the light emitting device 1 can be made smaller than those in the conventional technology.
   In addition, in the method of manufacturing the light emitting device 1 according to the present embodiment, since the LED elements 3 to 6 are embedded in the resin molded body 2 to be fixed in the resin molded body 2, mounting positions of the LED elements 3 to 6 of the light emitting device 1 are accurately determined according to installation positions of the LED elements 3 to 6 on the temporary fixing film 11 in the temporary fixing step. Thereby, the following effects can be obtained.
(3) As accuracy of the mounting positions in a planar direction (X-Y direction) of the LED elements 3 to 6 in the light emitting device 1, high accuracy of about ±50 µm in the LED element mounting machine can be obtained.
(4) Further, positional accuracy in a height direction (H direction) of the LED elements 3 to 6 in the light emitting device 1 can be reduced to within several µm of a variation degree of a coating thickness of the adhesive used in the temporary fixing step.
   In addition, since a heat treatment at 260 °C or higher required for curing a solder material in the conventional technology is unnecessary in the method of manufacturing the light emitting device 1 according to the present embodiment, the following effects can be obtained.
(5) Since high temperature heat is not applied to the LED elements 3 to 6, it is possible to prevent a change in light emitting characteristics of the LED elements 3 to 6.
   Further, since the method of manufacturing the light emitting device 1 according to the present embodiment does not include an additional step of the printed circuit board and a complicated step such as assembling the other members with the LED elements 3 to 6, the following effects can be obtained.
(6) It is possible to eliminate a factor lowering a manufacturing yield of the light emitting device 1, and to lower part costs and manufacturing costs of the light emitting device 1.

### (Modified example)

The arrangement of the LED elements 3 to 6 illustrated in Fig. 1(a) to Fig. 1(c) is merely an example. A plurality of LED elements included in the light emitting device 1 may be disposed in a matrix form inside the resin molded body 2, for example. Further, the light emitting device 1 may be configured to include a light emitting element other than the LED elements 3 to 6 such as an organic electro luminescence (EL) element or the like.

### [Embodiment 2]

Embodiment 2 of the present invention will be described below with reference to Fig 4(a) to Fig. 4(c). For convenience of description, members having the same functions as those described in the above embodiment will be denoted by the same reference signs, and description thereof will be omitted.

In Embodiment 1, the light emitting device 1 having the structure in which the light emitting units 32 to 62 of the LED elements 3 to 6 are exposed on the front surface of the resin molded body 2 has been described. However, the present invention is not limited thereto, and the light emitting device 1 may have a structure in which the light emitting units 32 to 62 are embedded in the resin molded body 2. In this case, it is necessary for the resin molded body 2 to have a certain level of light transmittance.

Fig. 4(a) to Fig. 4(c) are diagrams illustrating a structure of a light emitting device 1 according to Embodiment 2 of the present invention. As illustrated in Fig. 4(a) to Fig. 4(c), on an upper portion of light emitting units 32 to 62 of the light emitting device 1 according to the present embodiment, there may be a predetermined optical part (structure) for imparting directivity to light emitted from the light emitting units 32 to 62. In an example of Fig. 4(a) to Fig. 4(c), a lens 24 is provided on an upper portion of the light emitting unit 32, a prismatic polyhedron 25 is provided on an upper portion of the light emitting unit 42, and a concave-shaped light reflecting portion 26 is provided on an upper portion of the light emitting unit 52. The lens 24, the polyhedron 25, and the light reflecting portion 26 are formed as portions of a resin molded body 2 at the time of molding the resin molded body 2.

In the conventional technology, it is necessary to separately prepare such a member imparting directivity as a part separate from the LED element and to assemble the member to the LED element. This leads to problems such as complicated assembly of the light emitting device and high manufacturing costs. Further, in a light emitting device 101 having a configuration in which a plurality of LED elements 103 are mounted in an array as illustrated in Fig. 6(a) to Fig. 6(b), since there is a possibility of mounting positions of each of the LED elements 103 deviating, there is a problem in that high precision adjustment is required when optical parts such as the lens prepared as separate parts are aligned with the LED elements 103. Alternatively, as a result of poor positional alignment, there is also a problem in that a defect rate of the light emitting device 101 increases.

On the other hand, in the light emitting device 1 according to the present embodiment, the LED elements 3 to 6 are embedded in the resin molded body 2, and at the same time, optical parts such as the lens 24 are injection molded at embedded positions of the LED elements 3 to 6. Thereby, it is unnecessary to assemble optical parts such as the lens prepared as separate parts from the LED elements 3 to 6 to the LED elements 3 to 6. In addition, since there is little variation in mounting positions of the LED elements 3 to 6 as shown in Fig. 3, highly accurate positional adjustment between the LED elements 3 to 6 and the lens 24 or the like is unnecessary. Thereby, an incidence of defective products of the light emitting device 1 can be reduced.

### [Embodiment 3]

Embodiment 3 according to the present invention will be described below. For convenience of description, members having the same functions as those described in the above embodiment will be denoted by the same reference signs, and description thereof will be omitted.

In the conventional technology illustrated in Fig. 6(a) to Fig. 6(b), light emission from a light emitting unit 132 of each LED element 103 leaks, for example, also toward adjacent LED elements 103 in addition to an upper direction indicated by arrows in Fig. 6(a) to Fig. 6(b). Thereby, light emission from each LED element 103 interferes with each other. When the light emitting device 101 in such a state is used for an optical printer head or the like, such a problem in which a dot image is blurred or written and stored image qualities are deteriorated occurs.

Therefore, as a countermeasure against such a problem, in the present embodiment, a resin material having a light reflectance of 90% or higher is used as a material of the resin molded body 2 constituting the light emitting device 1. As an example of such a material, FULL BRIGHT (manufactured by Panasonic Co., Ltd.) which is a polypropylene (PP) based resin, EHR GRADE (manufactured by Mitsubishi Engineering-Plastic Corporation) which is a polycarbonate (PC) based resin, or the like can be exemplified.

In the light emitting device 1 having the resin molded body 2 formed of such a material, it is possible to prevent light emitted from the light emitting units 32 to 62 of the respective LED elements 3 to 6 from leaking toward the adjacent LED elements 3 to 6. Therefore, an effect of reducing interference between respective light emissions is obtained.

### [Embodiment 4]

Embodiment 4 according to the present invention will be described below. For convenience of explanation, members having the same functions as those described in the above embodiment are denoted by the same reference numerals, and description thereof is omitted.

In Embodiment 3, an example in which a resin material having a high light reflectance is used as the material of the resin molded body 2 in which the LED elements 3 to 6 are embedded has been described. However, the present invention is not limited thereto, and it is also possible to use a transparent resin material having a high light transmittance as the material of the resin molded body 2.

In the light emitting device 1 according to the present embodiment, as the material of the resin molded body 2 included in the light emitting device 1, a material having a light transmittance which transmits 80% or higher of visible light is used. As such a material, for example, transparent polycarbonate (PC), transparent acrylic resin, or the like can be exemplified.

In the light emitting device 1 having the resin molded body 2 formed of such a material, a light emitting area of the light emitting device 1 is wide, and light emission with good visibility and decorative properties is emitted from the light emitting device 1. Therefore, the light emitting device 1 can be suitably used in a switch having a light emitting display portion, an illumination device, or the like.

### [Embodiment 5]

Embodiment 5 according to the present invention will be described below. For convenience of explanation, members having the same functions as those described in the above embodiment are denoted by the same reference numerals, and description thereof is omitted.

In Embodiment 1, a method of using PC (polycarbonate) and ABS (acrylonitrile butadiene styrene) as the material of the resin molded body 2 in which the LED elements 3 to 6 are embedded has been described, but the present invention is not limited thereto. As the material of the resin molded body 2, a material having high thermal conductivity can also be used.

In recent years, an application of LED elements as light parts such as lighting has increased and problems occur due to heat generation of the LED elements caused by high luminance of LED elements accompanied by such a demand. Conventionally, as a countermeasure against such heat generation of LED elements, in the light emitting device 101 according to the conventional technology illustrated in Fig. 6(a) to Fig. 6(b), a method of using a metal such as an aluminum material for a printed circuit board 102, a method of using a special voltage boosting circuit to minimize heat generation of the LED elements, a method of using an electric wire used as interconnections of LED elements as a heat dissipation body, or the like is employed.

However, with such a conventional method, a problem occurs in that manufacturing costs of the light emitting device 101 increase due to an increase in substrate processing cost or complication of circuits, or a problem occurs in that sufficient heat dissipation cannot be obtained due to limitation of a size of the light emitting device 101.

Therefore, as a countermeasure against such a problem, in the light emitting device 1 according to the present embodiment, a material having thermal conductivity of 1 W/m·K or higher is used as the material of the resin molded body 2. As such a material, for example, a nylon-based resin mixed with TORELINA H718LB (manufactured by Toray Industries, Inc.) or high thermal conductive insulating filler manufactured by Unitika Ltd. can be exemplified.

In the light emitting device 1 having the resin molded body 2 formed of such a material, since the resin molded body 2 acts as a heat sink of a large area for dissipating the heat generated by the LED elements 3 to 6, it is possible to prevent problems caused by heat generation of the LED elements 3 to 6.

### [Embodiment 6]

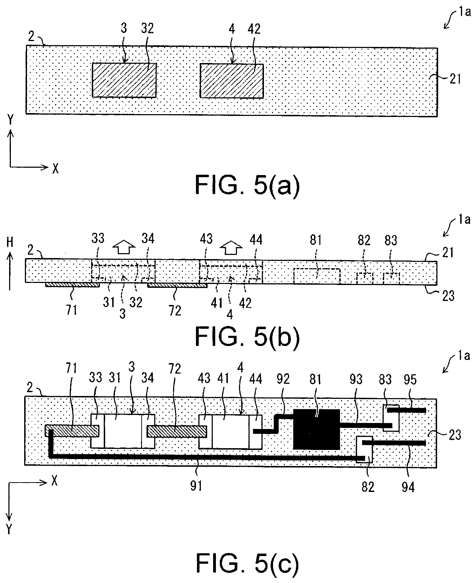

Embodiment 6 of the present invention will be described below with reference to Fig 5(a) to Fig. 5(c). For convenience of description, members having the same functions as those described in the above embodiment will be denoted by the same reference signs, and description thereof will be omitted.

In Embodiment 1, the light emitting device 1 in which only the LED elements 3 to 6 are embedded in the resin molded body 2 has been exemplified. It is necessary to connect a drive circuit to this light emitting device 1 as a separate part for driving the LED elements 3 to 6. However, the present invention is not limited thereto, and various types of electronic parts (chip parts) such as a drive integrated circuit (IC), a resistor, a capacitor, and the like which constitute the drive circuit for operating the LED elements 3 to 6 can be embedded in the resin molded body 2 in which the LED elements 3 to 6 are embedded. Thus, it is possible to manufacture a light emitting electronic device capable of operating the LED elements merely by supplying power.

Fig. 5(a) to Fig. 5(c) are diagrams illustrating a configuration of a light emitting device 1a according to Embodiment 6 of the present invention. Fig. 5(a) is a diagram of the light emitting device 1a viewed from a light emitting surface (front surface) thereof, Fig. 5(b) is a diagram of the light emitting device 1a viewed from a surface perpendicular to the light emitting surface (side surface), Fig. 5(c) is a diagram of the light emitting device 1a viewed from a surface opposite to the light emitting surface (back surface).

As illustrated in Fig. 5(a) to Fig. 5(c), the light emitting device 1a includes a resin molded body 2, an LED element 3, an LED element 4, an electronic part 81, an electronic part 82, and an electronic part 83 as well as an interconnection 71, an interconnection 72, and interconnections 91 to 95.

The electronic parts 81 to 83 are various types of electronic parts such as a drive IC, a resistor, and a capacitor, which constitute a drive circuit. The electronic parts 81 to 83 include connection electrodes (anode and cathode) (not illustrated) formed on their back surfaces, and these connection electrodes are embedded in the resin molded body 2 in a form of being exposed on the back surface 23 of the resin molded body 2.

The interconnections 91 to 95 are interconnections connected to the connection electrodes of the electronic parts 81 to 83 and are formed on the back surface 23 of the resin molded body 2 by a printing method using silver ink or the like as in the interconnections 71 and 72. Therefore, a soldering material for connecting the connection electrodes of the electronic parts 81 to 83 and the interconnections 91 to 95 is unnecessary.

As illustrated in Fig. 5(c), in the light emitting device 1a, one end of the interconnection 91 is connected to the electronic part 82 and the other end is connected to the other end of the interconnection 71. One end of the interconnection 92 is connected to the electronic part 81 and the other end is connected to a cathode 44. One end of the interconnection 93 is connected to the electronic part 83 and the other end is connected to the electronic part 81. One end of the interconnection 94 is connected to a power supply (not illustrated) outside the light emitting device 1a, and the other end is connected to the electronic part 82. One end of the interconnection 95 is connected to the power supply (not illustrated) outside the light emitting device 1a, and the other end is connected to the electronic part 83.

When the above configuration is employed, power from the power supply is supplied to the drive circuit constituted by the electronic parts 81 to 83. Also, since the LED elements 3 and 4 are connected in series to the drive circuit, the drive circuit can drive the LED elements 3 and 4. As described above, in the present embodiment, since the drive circuit is also embedded in the resin molded body 2 in which the LED elements 3 and 4 are embedded, there is no need to separately provide a drive circuit outside the light emitting device la. Thus, it is possible to reduce processing costs or interconnection costs for connecting a drive circuit to the light emitting device 1a.

In order to embed the electronic parts 81 to 83 according to the present embodiment in the resin molded body 2, a step similar to the step of temporary fixing the LED elements 3 to 6 to the temporary fixing film 11 in Embodiment 1 described with reference to Fig. 2(a) can be used. Further, in order to form the interconnections 91 to 95 on the back surface 23 of the resin molded body 2, a step similar to the step of print-forming the interconnections 71 to 75 in Embodiment 1 described with reference to Fig. 2(d) can be used.

The present invention is not limited to each of the above-described embodiments, and various modifications are possible within the scope indicated in the claims. Embodiments obtained by appropriately combining technical methods disclosed in different embodiments are also included in the technical scope of the present invention. New technical features can also be formed by combining technical methods disclosed in each embodiment.

### [Summary]

In order to solve the above problems, a light emitting device according to one aspect of the present invention is defined in the independent claim.

According to the above configuration, the light emitting element is mounted on the light emitting device in a form of being embedded in the resin molded body. Therefore, since a printed circuit board for mounting the light emitting element is not required, a height of the light emitting device can be made substantially the same as a height of the light emitting element (resin molded body). In addition, since the interconnection connected to the electrode of the light emitting element exposed on the back surface of the resin molded body can be formed by printing, there is no need to use a solder material for connection. Thereby, since spaces for the solder material between the light emitting elements are unnecessary, mounting pitches between the light emitting elements can be minimized.

As described above, according to the present invention, it is possible to realize a more compact and thinner light emitting device.

The light emitting device according to one aspect of the present invention is further characterized in that the light emitting unit is exposed on the front surface.

According to the above configuration, light from the light emitting unit is emitted from the front surface of the light emitting device without being obstructed by the resin molded body. Further, the resin molded body can be formed of a material having a low light transmittance.

The light emitting device according to one aspect of the present invention is further characterized in that the resin molded body is formed of a resin material having a light reflectance of 90% or higher.

According to the above configuration, in a case in which the light emitting device includes a plurality of light emitting elements, since it is possible to prevent light emitted from each of the light emitting elements from leaking toward adjacent light emitting elements, interference between the respective light emissions can be reduced.

The light emitting device according to one aspect of the present invention is further characterized in that the resin molded body is formed of a resin material having a light reflectance of 80% or higher.

According to the above configuration, the light emitting device emits light with good visibility and decorative properties.

The light emitting device according to one aspect of the present invention is further characterized in that the resin molded body is formed of a resin material having thermal conductivity of 1 W/m·K or higher.

According to the above configuration, since the heat generated by the light emitting element is easily released to the outside of the light emitting device through the resin molded body, the problem caused by heat generation can be prevented.

The light emitting device according to one aspect of the present invention is further characterized in that a plurality of light emitting elements are embedded in the resin molded body and the electrodes included in the respective light emitting elements are connected to each other by the interconnections.

According to the above configuration, it is possible to realize a light emitting device including a plurality of light emitting elements.

The light emitting device according to one aspect of the present invention is further characterized in that it further includes a drive circuit embedded in the resin molded body and driving the light emitting elements, in which the electrode and the drive circuit are connected to each other by the interconnection.

According to the above configuration, a light emitting device which emits light merely by supplying power can be realized.

The light emitting device according to one aspect of the present invention is further characterized in that an optical part which imparts directivity to light from the light emitting unit is formed on an upper portion of the light emitting unit of the resin molded body.

According to the above configuration, light to which directivity is imparted can be emitted from the light emitting device.

The light emitting device according to one aspect of the present invention is further characterized in that the light emitting element is a light emitting diode element.

According to the above configuration, a light emitting device with low power consumption can be realized.

In order to solve the above problems, a method of manufacturing a light emitting device according to one aspect of the present invention includes a step of temporarily fixing a light emitting element having at least a light emitting unit and an electrode on a temporary fixing film in a form in which the electrode comes into contact with the temporary fixing film, a step of forming a resin molded body in which the light emitting element is embedded by disposing the temporary fixing film to which the light emitting element is temporarily fixed in a gap in a mold and injecting a resin material into the gap, a step of peeling off the temporary fixing film from the resin molded body, and a step of forming an interconnection connected to the electrode on a back surface of the resin molded body from which the electrode is exposed.

According to the above configuration, it is possible to more easily manufacture a more compact and thinner light emitting device.

### [Reference Signs List]

### 1, 1a Light emitting device

2 Resin molded body
3 to 6 LED element (light emitting element)
11 Temporary fixing film
12, 13 Mold
24 Lens
25 Polyhedron
26 Light reflecting portion
31 to 61 Base portion
32 ~ 62 Light emitting unit
33 to 63 Anode (electrode)
34 to 64 Cathode (electrode)
71 to 75, 91 to 95 Interconnection
81 to 83 Electronic part

## Claims

1. A light emitting device (1, 1a) comprising:
a resin molded body (2), formed of a resin material;
a plurality of light emitting elements (3, 4, 5, 6), each light emitting element (3, 4, 5, 6) having at least a light emitting unit (32, 42, 52, 62) and an electrode (33, 34, 43, 44, 53, 54, 63, 64), wherein the plurality of light emitting elements (3, 4, 5, 6) are embedded in the resin molded body (2) so that the light emitting units (32, 42, 52, 62) face a front surface (21) of the resin molded body (2) and the electrodes (33, 34, 43, 44, 53, 54, 63, 64) are exposed on a back surface (23) opposite to the front surface (21) of the resin molded body (2), and the front surface (21) is the light emitting surface of the light emitting device (1, 1a); and
an interconnection (71, 72, 73, 74, 75, 91, 92, 93, 94, 95) formed on the back surface (23) of the resin molded body (2) and connected to the electrodes (33, 34, 43, 44, 53, 54, 63, 64),
wherein the electrodes (33, 34, 43, 44, 53, 54, 63, 64) included in the respective light emitting elements (3, 4, 5, 6) are connected in series to each other by the interconnection (71, 72, 73, 74, 75, 91, 92, 93, 94, 95), and
the light emitting device (1, 1a) is **characterized in that** the resin molded body (2) serves as a base of the light emitting device (1, 1a).

2. The light emitting device (1, 1a) according to claim 1, wherein the light emitting units (32, 42, 52, 62) are exposed on the front surface (21).

3. The light emitting device (1, 1a) according to claim 2, wherein the resin molded body (2) is formed of a resin material having a light reflectance of 90% or higher.

4. The light emitting device (1, 1a) according to claim 1 or 2, wherein the resin molded body (2) is formed of a resin material having a light reflectance of 80% or higher.

5. The light emitting device (1, 1a) according to any one of claims 1 to 4,
wherein the resin molded body (2) is formed of a resin material having thermal conductivity of 1 W/m·K or higher.

6. The light emitting device (1, 1a) according to any one of claims 1 to 5, further comprising a drive circuit (81, 82, 83) embedded in the resin molded body (2) and driving the light emitting elements (3, 4, 5, 6), wherein the electrodes (33, 34, 43, 44, 53, 54, 63, 64) and the drive circuit (81, 82, 83) are connected to each other by the interconnection (71, 72, 73, 74, 75, 91, 92, 93, 94, 95).

7. The light emitting device (1, 1a) according to any one of claims 1 to 6,
wherein an optical part (24, 25, 26) which imparts directivity to light from the light emitting units (32, 42, 52, 62) is formed on an upper portion of the light emitting units (32, 42, 52, 62) of the resin molded body (2).

8. The light emitting device (1, 1a) according to any one of claims 1 to 7,
wherein the light emitting elements (3, 4, 5, 6) are light emitting diode elements.

9. A method of manufacturing a light emitting device (1, 1a), comprising:
a step of temporarily fixing a plurality of light emitting elements (3, 4, 5, 6), each light emitting element (3, 4, 5, 6) having at least a light emitting unit (32, 42, 52, 62) and an electrode (33, 34, 43, 44, 53, 54, 63, 64), on a temporary fixing film (11) in a form in which the electrodes (33, 34, 43, 44, 53, 54, 63, 64) come into contact with the temporary fixing film (11);
a step of forming a resin molded body (2) in which the light emitting elements (3, 4, 5, 6) are embedded by disposing the temporary fixing film (11) to which the light emitting elements (3, 4, 5, 6) are temporarily fixed in a gap in a mold and injecting a resin material into the gap, wherein the plurality of light emitting elements (3, 4, 5, 6) are embedded in the resin molded body (2) so that the light emitting units (32, 42, 52, 62) face a front surface (21) of the resin molded body (2) and the front surface (21) is the light emitting surface of the light emitting device (1, la);
a step of peeling off the temporary fixing film from the resin molded body (2) ;
a step of forming an interconnection (71, 72, 73, 74, 75, 91, 92, 93, 94, 95) connected to the electrodes (33, 34, 43, 44, 53, 54, 63, 64) on a back surface (23) of the resin molded body from which the electrodes (33, 34, 43, 44, 53, 54, 63, 64) are exposed, the back surface (23) being opposite to the front surface (21) of the resin molded body (2),
wherein the electrodes (33, 34, 43, 44, 53, 54, 63, 64) included in the respective light emitting elements (3, 4, 5, 6) are connected in series to each other by the interconnection (71, 72, 73, 74, 75, 91, 92, 93, 94, 95), and
the method is **characterized in that**
the resin molded body (2) serves as a base of the light emitting device (1, 1a).

## Patentansprüche

1. Lichtemittierende Vorrichtung (1, 1a), umfassend:
einen Harzformkörper (2), der aus einem Harzmaterial gebildet ist;
eine Vielzahl von lichtemittierenden Elementen (3, 4, 5, 6), wobei jedes lichtemittierende Element (3, 4, 5, 6) wenigstens eine lichtemittierende Einheit (32, 42, 52, 62) und eine Elektrode (33, 34, 43, 44, 53, 54, 63, 64) aufweist, wobei die Vielzahl von lichtemittierenden Elementen (3, 4, 5, 6) in den Harzformkörper (2) eingebettet ist, so dass die lichtemittierenden Einheiten (32, 42, 52, 62) einer Vorderseite (21) des Harzformkörpers (2) zugewandt sind und die Elektroden (33, 34, 43, 44, 53, 54, 63, 64) auf einer der Vorderseite (21) des Harzformkörpers (2) gegenüberliegenden Rückseite (23) freigelegt sind, und die Vorderseite (21) die lichtemittierende Fläche der lichtemittierenden Vorrichtung (1, 1a) ist; und
eine Verbindung (71, 72, 73, 74, 75, 91, 92, 93, 94, 95), die auf der Rückseite (23) des Harzformkörpers (2) gebildet und mit den Elektroden (33, 34, 43, 44, 53, 54, 63, 64) verbunden ist,
wobei die in den jeweiligen lichtemittierenden Elementen (3, 4, 5, 6) eingeschlossenen Elektroden (33, 34, 43, 44, 53, 54, 63, 64) durch die Verbindung (71, 72, 73, 74, 75, 91, 92, 93, 94, 95) in Reihe miteinander verbunden sind, und
die lichtemittierende Vorrichtung (1, 1a) **dadurch gekennzeichnet ist, dass** der Harzformkörper (2) als eine Basis der lichtemittierenden Vorrichtung (1, 1a) dient.

2. Lichtemittierende Vorrichtung (1, 1a) nach Anspruch 1, wobei die lichtemittierenden Einheiten (32, 42, 52, 62) auf der Vorderseite (21) freigelegt sind.

3. Lichtemittierende Vorrichtung (1, 1a) nach Anspruch 2, wobei der Harzformkörper (2) aus einem Harzmaterial mit einem Lichtreflexionsgrad von 90 % oder höher gebildet ist.

4. Lichtemittierende Vorrichtung (1, 1a) nach Anspruch 1 oder 2, wobei der Harzformkörper (2) aus einem Harzmaterial mit einem Lichtreflexionsgrad von 80 % oder höher gebildet ist.

5. Lichtemittierende Vorrichtung (1, 1a) nach einem der Ansprüche 1 bis 4, wobei der Harzformkörper (2) aus einem Harzmaterial mit einer Wärmeleitfähigkeit von 1 W/m·K oder höher gebildet ist.

6. Lichtemittierende Vorrichtung (1, 1a) nach einem der Ansprüche 1 bis 5, ferner umfassend eine Antriebsschaltung (81, 82, 83), die in den Harzformkörper (2) eingebettet ist und die lichtemittierenden Elemente (3, 4, 5, 6) ansteuert, wobei die Elektroden (33, 34, 43, 44, 53, 54, 63, 64) und die Antriebsschaltung (81, 82, 83) über die Verbindung (71, 72, 73, 74, 75, 91, 92, 93, 94, 95) miteinander verbunden sind.

7. Lichtemittierende Vorrichtung (1, 1a) nach einem der Ansprüche 1 bis 6, wobei ein optisches Teil (24, 25, 26), das dem Licht von den lichtemittierenden Einheiten (32, 42, 52, 62) Richtwirkung verleiht, an einem oberen Abschnitt der lichtemittierenden Einheiten (32, 42, 52, 62) des Harzformkörpers (2) gebildet ist.

8. Lichtemittierende Vorrichtung (1, 1a) nach einem der Ansprüche 1 bis 7, wobei die lichtemittierenden Elemente (3, 4, 5, 6) lichtemittierende Diodenelemente sind.

9. Verfahren zur Herstellung einer lichtemittierenden Vorrichtung (1, 1a), umfassend:
einen Schritt des vorübergehenden Befestigens einer Vielzahl von lichtemittierenden Elementen (3, 4, 5, 6), wobei jedes lichtemittierende Element (3, 4, 5, 6) wenigstens eine lichtemittierende Einheit (32, 42, 52, 62) und eine Elektrode (33, 34, 43, 44, 53, 54, 63, 64) aufweist, auf einem vorübergehenden Befestigungsfilm (11) in einer Form, in der die Elektroden (33, 34, 43, 44, 53, 54, 63, 64) mit dem vorübergehenden Befestigungsfilm (11) in Kontakt kommen;
einen Schritt des Bildens eines Harzformkörpers (2), in dem die lichtemittierenden Elemente (3, 4, 5, 6) eingebettet sind, durch Anordnen des vorübergehenden Befestigungsfilms (11), an dem die lichtemittierenden Elemente (3, 4, 5, 6) vorübergehend in einem Spalt in einer Form befestigt sind, und Einspritzen eines Harzmaterials in den Spalt, wobei die mehreren lichtemittierenden Elemente (3, 4, 5, 6) in den Harzformkörper (2) eingebettet sind, so dass die lichtemittierenden Einheiten (32, 42, 52, 62) einer Vorderseite (21) des Harzformkörpers (2) zugewandt sind und die Vorderseite (21) die lichtemittierende Fläche der lichtemittierenden Vorrichtung (1, 1a) ist;
einen Schritt des Abziehens des vorübergehenden Befestigungsfilms von dem Harzformkörper (2);
einen Schritt des Bildens einer Verbindung (71, 72, 73, 74, 75, 91, 92, 93, 94, 95), die mit den Elektroden (33, 34, 43, 44, 53, 54, 63, 64) verbunden ist, auf einer Rückseite (23) des Harzformkörpers, von der aus die Elektroden (33, 34, 43, 44, 53, 54, 63, 64) freigelegt sind, die Rückseite (23) der Vorderseite (21) des Harzformkörpers (2) gegenüberliegt,
wobei die in den jeweiligen lichtemittierenden Elementen (3, 4, 5, 6) eingeschlossenen Elektroden (33, 34, 43, 44, 53, 54, 63, 64) durch die Verbindung (71, 72, 73, 74, 75, 91, 92, 93, 94, 95) in Reihe miteinander verbunden sind, und
das Verfahren **dadurch gekennzeichnet ist, dass**
der Harzformkörper (2) als eine Basis der lichtemittierenden Vorrichtung (1, 1a) dient.

## Revendications

1. Dispositif électroluminescent (1, 1a) comprenant :
un corps moulé de résine (2), constitué d'un matériau de résine ;
une pluralité d'éléments électroluminescents (3, 4, 5, 6), chaque élément électroluminescent (3, 4, 5, 6) ayant au moins une unité électroluminescente (32, 42, 52, 62) et une électrode (33, 34, 43, 44, 53, 54, 63, 64), dans lequel la pluralité d'éléments électroluminescents (3, 4, 5, 6) sont intégrés dans le corps moulé de résine (2) de sorte que les unités électroluminescentes (32, 42, 52, 62) soient face à une surface avant (21) du corps moulé de résine (2) et les électrodes (33, 34, 43, 44, 53, 54, 63, 64) soient exposées sur une surface arrière (23) à l'opposé de la surface avant (21) du corps moulé de résine (2), et la surface avant (21) est la surface électroluminescente du dispositif électroluminescent (1, 1a) ; et
une interconnexion (71, 72, 73, 74, 75, 91, 92, 93, 94, 95) constituée sur la surface arrière (23) du corps moulé de résine (2) et reliée aux électrodes (33, 34, 43, 44, 53, 54, 63, 64),
dans lequel les électrodes (33, 34, 43, 44, 53, 54, 63, 64) incluses dans les éléments électroluminescents (3, 4, 5, 6) respectifs sont reliées en série les unes aux autres par l'interconnexion (71, 72, 73, 74, 75, 91, 92, 93, 94, 95), et
le dispositif électroluminescent (1, 1a) est **caractérisé en ce que** le corps moulé de résine (2) sert de base du dispositif électroluminescent (1, 1a).

2. Dispositif électroluminescent (1, 1a) selon la revendication 1, dans lequel les unités électroluminescentes (32, 42, 52, 62) sont exposées sur la surface avant (21).

3. Dispositif électroluminescent (1, 1a) selon la revendication 2, dans lequel le corps moulé de résine (2) est constitué d'un matériau de résine ayant une réflectance lumineuse de 90 % ou plus.

4. Dispositif électroluminescent (1, 1a) selon la revendication 1 ou 2, dans lequel le corps moulé de résine (2) est constitué d'un matériau de résine ayant une réflectance lumineuse de 80 % ou plus.

5. Dispositif électroluminescent (1, 1a) selon l'une quelconque des revendications 1 à 4, dans lequel le corps moulé de résine (2) est constitué d'un matériau de résine ayant une conductivité thermique de 1 W/m.K ou plus.

6. Dispositif électroluminescent (1, 1a) selon l'une quelconque des revendications 1 à 5, comprenant en outre un circuit d'entraînement (81, 82, 83) intégré dans le corps moulé de résine (2) et entraînant les éléments électroluminescents (3, 4, 5, 6), dans lequel les électrodes (33, 34, 43, 44, 53, 54, 63, 64) et le circuit d'entraînement (81, 82, 83) sont reliés les uns aux autres par l'interconnexion (71, 72, 73, 74, 75, 91, 92, 93, 94, 95).

7. Dispositif électroluminescent (1, 1a) selon l'une quelconque des revendications 1 à 6, dans lequel une partie optique (24, 25, 26) qui applique une directivité à une lumière provenant des unités électroluminescentes (32, 42, 52, 62) est constituée sur une partie supérieure des unités électroluminescentes (32, 42, 52, 62) du corps moulé de résine (2).

8. Dispositif électroluminescent (1, 1a) selon l'une quelconque des revendications 1 à 7, dans lequel les éléments électroluminescents (3, 4, 5, 6) sont des éléments à diodes électroluminescentes.

9. Procédé de fabrication d'un dispositif électroluminescent (1, 1a), comprenant :
une étape de fixation provisoire d'une pluralité d'éléments électroluminescents (3, 4, 5, 6), chaque élément électroluminescent (3, 4, 5, 6) ayant au moins une unité électroluminescente (32, 42, 52, 62) et une électrode (33, 34, 43, 44, 53, 54, 63, 64), sur un film de fixation provisoire (11) dans une forme dans laquelle les électrodes (33, 34, 43, 44, 53, 54, 63, 64) viennent en contact avec le film de fixation provisoire (11) ;
une étape de constitution d'un corps moulé de résine (2) dans lequel les éléments électroluminescents (3, 4, 5, 6) sont intégrés par la disposition du film de fixation provisoire (11) auquel les éléments électroluminescents (3, 4, 5, 6) sont provisoirement fixés dans un espacement dans un moule et l'injection d'un matériau de résine dans l'espacement, dans lequel la pluralité d'éléments électroluminescents (3, 4, 5, 6) sont intégrés dans le corps moulé de résine (2) de sorte que les unités électroluminescentes (32, 42, 52, 62) soient face à une surface avant (21) du corps moulé de résine (2) et la surface avant (21) soit la surface électroluminescente du dispositif électroluminescent (1, 1a) ;
une étape de pelage du film de fixation provisoire depuis le corps moulé de résine (2) ;
une étape de constitution d'une interconnexion (71, 72, 73, 74, 75, 91, 92, 93, 94, 95) reliée aux électrodes (33, 34, 43, 44, 53, 54, 63, 64) sur une surface arrière (23) du corps moulé de résine sur laquelle les électrodes (33, 34, 43, 44, 53, 54, 63, 64) sont exposées, la surface arrière (23) étant à l'opposé de la surface avant (21) du corps moulé de résine (2),
dans lequel les électrodes (33, 34, 43, 44, 53, 54, 63, 64) incluses dans les éléments électroluminescents (3, 4, 5, 6) respectifs sont reliées en série les unes aux autres par l'interconnexion (71, 72, 73, 74, 75, 91, 92, 93, 94, 95), et
le procédé est **caractérisé en ce que**
le corps moulé de résine (2) sert de base du dispositif électroluminescent (1, 1a).
